# FASCICULE DE BREVET EUROPEEN

(11) **EP 4 208 429 B1**
(45) Date de publication et mention de la délivrance du brevet: **25.09.2024**
(21) Numéro de dépôt: 21770054.1
(22) Date de dépôt: 25.08.2021
(51) Int. Cl.: C04B 35/573, C04B 35/628, C04B 35/80, C04B 35/626

(54) **PROCEDE DE REVETEMENT DE FIBRES EN LIT FLUIDISE**
VERFAHREN ZUR BESCHICHTUNG VON FASERN IN EINEM WIRBELBETT
METHOD FOR COATING FIBRES IN A FLUIDIZED BED

(30) Priorité: 01.09.2020 FR 2008867
(43) Date de publication de la demande: 12.07.2023
(73) Titulaire: Safran Ceramics, 33185 Le Haillan (FR); Centre national de la recherche scientifique, 75016 Paris (FR); Université de Bordeaux, 33000 Bordeaux (FR)
(72) Inventeur: DELEHOUZE, Arnaud, 77550 Moissy-Cramayel (FR); BOUILLON, Eric, 77550 Moissy-Cramayel (FR); EL MANSOURI, Amine, 33000 Bordeaux (FR); BERTRAND, Nathalie, Dominique, 33490 Saint-Maixant (FR); GUETTE, Alain, Jean-Michel, 33110 Le Bouscat (FR)
(74) Mandataire: Cabinet Beau de Loménie
(86) Numéro de dépôt international: PCT/FR2021/051485
(87) Numéro de publication internationale: WO 2022/049336

(56) Documents cités:
- EP-A2- 0 258 027
- FR-A1- 2 939 130
- FR-A1- 2 981 643
- US-A- 6 143 376

## Description

### Domaine Technique

La présente invention concerne un procédé de revêtement de fibres courtes par dépôt chimique en phase vapeur en lit fluidisé.

### Technique antérieure

Les matériaux composites à matrice céramique (matériaux CMC) possèdent de bonnes propriétés thermostructurales, c'est-à-dire des propriétés mécaniques élevées qui les rendent aptes à constituer des pièces structurales, et la capacité de conserver ces propriétés à hautes températures. Les pièces CMC peuvent comprendre un renfort textile constitué de fibres longues et continues tissées suivant les directions de sollicitation de la pièce composite finale. L'étape de tissage est une étape coûteuse et l'utilisation d'un renfort fibreux tissé peut présenter des limitations dans le cas des pièces de géométrie complexe ou de petite taille. En effet, le pas minimum de tissage peut s'avérer trop grossier pour la réalisation d'un détail géométrique de faible dimension.

Afin de résoudre ce problème, il a été envisagé d'utiliser un renfort non plus constitué de fibres longues continues mais de fibres courtes dispersées dans la matrice. Cependant, il est bien connu que le fonctionnement d'un matériau CMC, nécessite une gestion spécifique des liaisons interfaciales entre fibres et matrice, afin d'accéder au caractère endommageable du composite final. Cette modulation des interfaces est obtenue, classiquement par interposition d'une interphase entre la fibre et la matrice.

En plus du revêtement d'interphase, il peut s'avérer souhaitable dans certains cas de protéger le renfort fibreux par un revêtement supplémentaire réfractaire pour protéger les fibres vis-à-vis des agressions résultant des étapes ultérieures de formation de la matrice.

Dans le cas des renforts fibreux tissés, la formation d'interphase et du revêtement supplémentaire réfractaire peuvent être réalisés par infiltration chimique en phase vapeur. Cette technique de dépôt n'est toutefois pas directement applicable pour revêtir des fibres courtes. En effet, un amas de fibres courtes traité par technique classique d'infiltration chimique en phase vapeur aboutira à un agglomérat, partiellement consolidé, résultant de collage fibre-à-fibre, par le revêtement déposé, et donc à des fibres qui ne sont pas revêtues de manière unitaire. Une autre solution envisageable serait de revêtir des fibres longues continues par défilement dans une enceinte de dépôt chimique en phase vapeur puis de couper ces fibres longues revêtues à la longueur souhaitée pour obtenir des fibres courtes revêtues. Toutefois, l'étape de découpe pour obtenir des fibres courtes peut conduire à un revêtement inhomogène sur les fibres coupées, voire à un endommagement de ce dernier. Un revêtement inhomogène peut conduire à une attaque chimique des fibres par le silicium fondu utilisé pour former la matrice par technique d'infiltration à l'état fondu et donc à une dégradation des propriétés mécaniques de la pièce. US 6 143 376 ! divulgue un procédé de revêtement de fibres.

Il est donc souhaitable de disposer d'un procédé permettant de limiter, voire de supprimer, la formation d'agrégats lors du revêtement de fibres courtes et d'améliorer l'homogénéité du revêtement formé.

### Exposé de l'invention

La présente invention concerne un procédé de revêtement de fibres, comprenant au moins :
- le désensimage, par exemple par traitement thermique, de fibres courtes ensimées ayant une longueur moyenne inférieure ou égale à 5 mm, les fibres courtes étant en matériau céramique ou en carbone,
- le tamisage des fibres courtes désensimées afin de les séparer d'éventuels agglomérats de fibres courtes ensimées encore présents,
- l'introduction des fibres courtes désensimées et tamisées dans un réacteur, et
- le revêtement des fibres courtes dans le réacteur par dépôt chimique en phase vapeur en lit fluidisé.

Un tamisage est effectué après désensimage afin de réduire la présence, voire éliminer les agglomérats de fibres, avant revêtement des fibres courtes en lit fluidisé. De la sorte, on obtient des fibres courtes revêtues de manière unitaire et homogène. Les fibres courtes ainsi revêtues peuvent ainsi être utilisées pour former le renfort fibreux discontinu d'une pièce en matériau composite. L'invention trouve un intérêt particulier pour la réalisation de pièces en matériau composite de petite taille ou de géométrie complexe mais n'est toutefois pas limitée à ces applications. Durant le tamisage, les fibres peuvent passer au travers d'un tamis ayant une pluralité de trous présentant une taille moyenne inférieure ou égale à 500 µm, par exemple inférieure ou égale à 400 µm, par exemple inférieure ou égale à 250 µm, par exemple inférieure ou égale à 200 µm.

De telles valeurs fines pour les trous du tamis participent avantageusement à réduire davantage encore le risque de présence d'agglomérats de fibres et à resserrer la distribution de longueur des fibres courtes, améliorant ainsi davantage encore le caractère unitaire et l'homogénéité du revêtement formé.

Sauf mention contraire, une dimension « moyenne » désigne la dimension donnée par la distribution granulométrique statistique à la moitié de la population, dite d₅₀. Dans un exemple de réalisation, le tamisage des fibres courtes désensimées comprend un passage de ces fibres au travers d'un premier tamis ayant une pluralité de premiers trous présentant une première taille moyenne afin d'obtenir un premier tamisat, et un passage du premier tamisat au travers d'un deuxième tamis ayant une pluralité de deuxièmes trous présentant une deuxième taille moyenne inférieure à la première taille moyenne afin d'obtenir un deuxième tamisat formant les fibres courtes désensimées et tamisées.

Une telle caractéristique participe à réduire davantage encore le risque de présence d'agglomérats de fibres et améliorer ainsi davantage encore le caractère unitaire et l'homogénéité du revêtement formé.

En particulier, la première taille moyenne peut être inférieure ou égale à 500 µm et la deuxième taille moyenne inférieure ou égale à 200 µm.

Dans un exemple de réalisation, on réalise, durant le revêtement, un brassage des fibres courtes à l'aide d'un organe de brassage.

Une telle caractéristique participe à réduire davantage encore le risque de présence d'agglomérats de fibres et améliorer ainsi davantage encore le caractère unitaire et l'homogénéité du revêtement formé.

Dans un exemple de réalisation, on impose un mouvement de vibration audit réacteur durant le revêtement à l'aide d'un organe vibrant.

Une telle caractéristique participe à réduire davantage encore le risque de présence d'agglomérats de fibres et améliorer ainsi davantage encore le caractère unitaire et l'homogénéité du revêtement formé.

Dans un exemple de réalisation, les fibres courtes sont en carbure de silicium. Bien entendu, les fibres courtes peuvent en variante être formées d'un autre matériau comme le carbone, un oxyde ou un nitrure.

Dans un exemple de réalisation, on dépose sur les fibres courtes durant le revêtement au moins une couche de : carbone pyrolytique, de nitrure de bore, de nitrure de bore dopé au silicium, de nitrure de silicium ou de carbone dopé au bore. Ce type de revêtement peut en particulier être combiné à l'emploi de fibres en carbure de silicium.

L'invention vise également un procédé de fabrication d'une pièce en matériau composite, comprenant au moins :
- la mise en oeuvre d'un procédé tel que décrit plus haut afin d'obtenir des fibres courtes revêtues,
- la mise en forme des fibres courtes revêtues de sorte à former une préforme poreuse de la pièce à obtenir, et
- la formation d'une matrice dans la porosité de la préforme afin d'obtenir la pièce en matériau composite.

Dans un exemple de réalisation, la matrice est formée par infiltration d'une composition de silicium fondu ou d'un alliage de silicium fondu dans la porosité de la préforme.

L'invention vise également un procédé de fabrication d'une pièce en matériau composite, comprenant au moins :
- la mise en oeuvre d'un procédé tel que décrit plus haut afin d'obtenir des fibres courtes revêtues,
- le mélange des fibres courtes revêtues avec le matériau de matrice ou avec un précurseur de matrice, et
- l'introduction du mélange ainsi obtenu dans un moule et le traitement thermique du mélange introduit afin d'obtenir la pièce en matériau composite.

Dans un exemple de réalisation, la matrice comprend au moins une phase de matrice céramique, par exemple une phase de matrice en carbure de silicium.

Dans un exemple de réalisation, la pièce peut être une pièce de turbomachine, par exemple une pièce de turbomachine aéronautique ou de turbomachine industrielle.

### Brève description des dessins

[Fig. 1] La figure 1 illustre, de manière schématique et partielle, un dispositif pour la mise en oeuvre d'un dépôt chimique en phase vapeur en lit fluidisé utilisable dans le cadre de l'invention.
[Fig. 2] La figure 2 représente, de manière schématique et partielle, la séparation des fibres courtes par un organe de brassage dans une variante de procédé selon l'invention.
[Fig. 3] La figure 3 fournit des photographies obtenues par microscopie électronique à balayage de fibres courtes qui ont été revêtues par mise en oeuvre de l'invention.

### Description des modes de réalisation

Les fibres courtes sont initialement désensimées par traitement thermique. Ce traitement thermique d'élimination de l'ensimage peut être par exemple être réalisé à une température supérieure ou égale à 700°C sous débit de N₂ pendant une durée allant de 1 heure à 2 heures. Le désensimage peut être fait en lit fluidisé.

Les fibres courtes ainsi désensimées sont ensuite tamisées par passage au travers d'un tamis ou de plusieurs tamis dont la taille moyenne des trous est décroissante. Dans le cas où les fibres passent successivement au travers de deux tamis ayant respectivement des trous d'une première taille moyenne et d'une deuxième taille moyenne inférieure à la première taille moyenne, la première taille moyenne peut être comprise entre 200 µm et 500 µm, par exemple entre 350 µm et 450 µm ou entre 400 µm et 500 µm, et la deuxième taille moyenne peut être comprise entre 100 µm et 200 µm, par exemple entre 150 µm et 200 µm. La première taille moyenne peut par exemple être sensiblement égale à 200 µm et la deuxième taille moyenne sensiblement égale à 100 µm.

Une fois les fibres désensimées et tamisées, elles peuvent être introduites dans un réacteur afin de procéder à un dépôt chimique en phase vapeur en lit fluidisé.

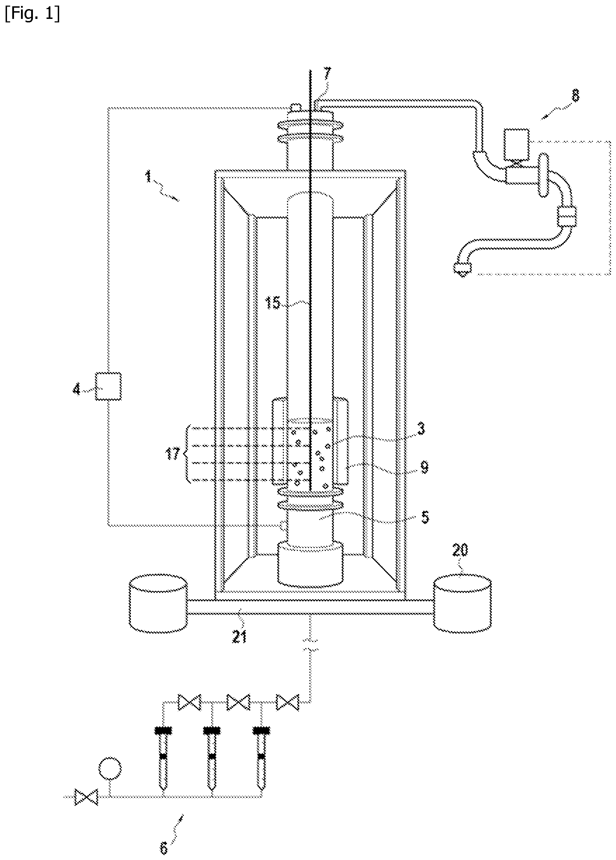

On va décrire en lien avec la figure 1 la structure d'un dispositif 1 utile pour la mise en oeuvre d'un procédé de revêtement selon l'invention. Le dépôt chimique en phase vapeur en lit fluidisé est une technique connue en soi.

Le dispositif 1 comprend un réacteur 3 défini par une paroi laquelle peut être en quartz, en Inconel^{®} ou en alumine. Le réacteur 3 comprend une entrée 5 en communication avec une source de gaz 6 au travers de laquelle la phase gazeuse comprenant le précurseur du revêtement à former est destinée à être introduite dans le réacteur 3. Le réacteur 3 comprend en outre une sortie 7 en communication avec un système de pompage 8 afin d'assurer la réalisation d'un vide dans le réacteur 3. Le dispositif 1 comprend un système de chauffage 9 apte à chauffer l'intérieur du réacteur 3 afin de permettre la formation du revêtement à partir du précurseur introduit par dépôt chimique en phase vapeur. Afin de stabiliser la température du réacteur 3 durant le revêtement, le réacteur 3 peut être muni au niveau de l'entrée 5 d'un élément isolant thermique.

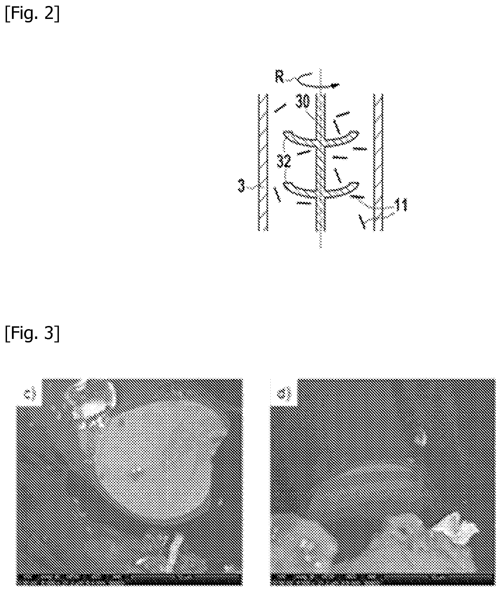

Les fibres courtes 11 à revêtir sont présentes à l'intérieur du réacteur 3 (voir figures 2). Les fibres courtes 11 peuvent avoir une longueur moyenne inférieure ou égale à 1 mm, par exemple inférieure ou égale à 500 µm. La longueur moyenne des fibres courtes peut être comprise entre 100 µm et 5 mm, par exemple entre 100 µm et 1 mm, par exemple entre 100 µm et 500 µm. Les fibres courtes 11 peuvent avoir un diamètre moyen inférieur ou égal à 20 µm, par exemple compris entre 5 µm et 20 µm, voire entre 8 µm et 14 µm. Les fibres courtes 11 peuvent être obtenues à partir de fibres longues par découpe mécanique ou broyage.

Les fibres courtes 11 sont en matériau céramique ou en carbone. Les fibres courtes peuvent être en matériau céramique carbure, nitrure ou oxyde. On peut en particulier mettre en oeuvre des fibres courtes 11 en carbure de silicium, ayant par exemple une teneur en oxygène inférieure ou égale à 1% en pourcentage atomique. De telles fibres courtes 11 peuvent être des fibres du type Hi-Nicalon type S commercialisées par la société NGS.

Les fibres courtes à revêtir peuvent en particulier constituer la seule phase solide dans le lit fluidisé. On notera que le traitement de désensimage décrit plus haut peut être réalisé dans le réacteur 3 puis les fibres courtes désensimées peuvent être retirées de ce réacteur 3 pour être tamisées puis réintroduites dans le réacteur 3 afin de réaliser le revêtement en lit fluidisé.

Dans la figure 2, les dimensions des fibres courtes 11 ont été exagérées pour des raisons de lisibilité.

La figure 2 illustre le cas où l'on brasse le mélange des fibres courtes 11 durant le revêtement afin de réduire davantage encore le risque d'obtention d'agrégats parasites. Cette figure illustre le phénomène de fluidisation du lit comprenant les fibres courtes 11 dans lequel chaque fibre courte 11 est séparée des autres et « baigne » dans le mélange de précurseur gazeux introduit dans le réacteur 3. Le dispositif comprend un organe de brassage comprenant un élément 30 rotatif autour de son axe et portant un ou plusieurs organes de brassage 32, par exemple une ou plusieurs pales de brassage 32. L'axe de rotation de l'élément rotatif 30 peut être colinéaire avec la hauteur du réacteur 3. Les organes de brassage 32 sont positionnés dans le lit formé par les fibres courtes 11. Le mouvement des organes de brassage 32 (rotation schématisée par la flèche R à la figure 3) permet de casser les agglomérats de fibres. On pourrait selon une variante non illustrée, positionner en amont de la zone du lit à fluidiser, un élément de perturbation de l'écoulement de la phase gazeuse. Dans cette variante, ce sont les turbulences induites au gaz porteur qui servent à réduire le risque d'apparition d'agrégats parasites. Bien entendu, on peut combiner ces différentes techniques de réduction du risque d'apparition d'agrégats parasites.

Dans l'exemple de dispositif 1 considéré à la figure 1, on peut également faire vibrer le réacteur 3 durant le revêtement afin de réduire davantage encore le risque d'obtention d'agrégats parasites. Cette vibration est assurée par un organe vibrant comprenant un ou plusieurs moteurs de vibration 20 et un support vibrant 21 destiné à être mis en vibration par les moteurs 20 et à communiquer cette vibration au réacteur 3. Le support vibrant 21 peut être sous la forme d'un plateau mais on ne sort pas du cadre de l'invention lorsqu'il présente une forme différente. La fréquence du mouvement de vibration imposé au réacteur 3 peut être comprise entre 10Hz et 70Hz, préférentiellement entre 20Hz et 50Hz. Dans l'exemple illustré, le mouvement de vibration imposé au réacteur 3 est un mouvement rectiligne le long de la hauteur du réacteur 3. On ne sort toutefois pas du cadre de l'invention si l'on modifie la direction du mouvement de vibration, en imposant par exemple une vibration le long du diamètre du réacteur ou encore une vibration non rectiligne, par exemple curviligne voire circulaire. Le fait d'imposer un mouvement de vibration rectiligne au réacteur 3 est toutefois préférentiel.

La phase gazeuse introduite dans le réacteur 3 pour la réalisation du revêtement est fonction de la nature du revêtement à obtenir et il va des connaissances générales de l'homme du métier de la choisir et de choisir les conditions de dépôt associées, en termes de température, pression et débit. La phase gazeuse comprend typiquement un gaz porteur, inerte, comme du diazote. On peut utiliser des précurseurs gazeux dans les conditions standards, auquel cas ils peuvent être mélangés au gaz porteur avant leur introduction dans le réacteur 3. On peut encore utiliser des précurseurs liquides dans les conditions standards, auquel cas le gaz porteur peut buller dans le précurseur liquide pour s'en enrichir et être ensuite introduit dans le réacteur 3. On peut aussi utiliser un système d'injection de liquide directe (« Direct Liquid Injection » ; « DLI »).

Dans l'exemple non limitatif d'un dépôt d'un revêtement en pyrocarbone, on peut utiliser du diazote en tant que gaz porteur. Le débit d'introduction du gaz porteur dans un réacteur 3 de diamètre 5 cm et de 1 m de hauteur peut être compris entre 500 centimètres cubes standards par minute et 3000 centimètres cubes standards par minute, par exemple entre 750 centimètres cubes standards par minute et 1250 centimètres cubes standards par minute. La température imposée à l'intérieur du réacteur 3 peut être comprise entre 850°C et 1100°C, par exemple entre 925°C et 1000°C. On peut utiliser, dans ce cas non limitatif, du méthane en tant que précurseur du pyrocarbone à déposer. Son débit est compris entre 5% et 30% du débit du gaz porteur, par exemple entre 10% et 20% du débit du gaz porteur. A titre d'exemple, on peut citer d'autres précurseurs pour le pyrocarbone, comme des précurseurs gazeux tels que le propane, les mélanges méthane/propane ou le gaz naturel. On peut encore citer des précurseurs liquides comme le toluène, le cyclohexane ou l'éthanol.

L'homme du métier veillera lors de la mise en oeuvre de l'invention à obtenir un phénomène de fluidisation durant le revêtement, comme habituellement réalisé dans les procédés de dépôt chimique en phase vapeur en lit fluidisé. Pour permettre le suivi de la fluidisation, le dispositif 1 comprend un capteur 4 de pression différentielle, permettant l'évaluation de la perte de charge du gaz à la traversée du lit. L'homme du métier peut avantageusement maintenir cette perte de charge à une valeur proche (+/- 20%) du rapport entre le poids du lit et la section du réacteur 3 afin de garantir l'état de fluidisation. L'homme du métier peut aussi veiller à avoir une relative homogénéité de température à l'intérieur du lit. Cette propriété thermique, caractéristique des lits fluidisés fonctionnant de manière optimale, est obtenue par la présence de bulles qui assurent une excellente agitation des fibres courtes. Les transferts thermiques au sein du lit sont ainsi largement favorisés. Des thermocouples 17 situés à l'intérieur d'une gaine 15 centrée au niveau du réacteur 3 sont disposés à différentes positions du lit fluidisé et permettent de contrôler l'iso thermicité du lit. La qualité de la fluidisation peut donc être évaluée à partir de l'écart maximal des températures affichées par les thermocouples. Par exemple, l'homme du métier pourra effectuer le dépôt avec un écart maximal de température inférieur ou égal à 20°C, pour des dépôts à température élevée (supérieure à 800°C).

Le revêtement déposé peut comporter au moins une couche de carbone pyrolytique (PyC), de nitrure de bore (BN), de nitrure de bore dopé au silicium (BN(Si), avec du silicium en une proportion massique comprise entre 5% et 40%, le complément étant du nitrure de bore), du nitrure de silicium Si₃N₄ ou de carbone dopé au bore (BC, avec du bore en une proportion atomique comprise entre 5% et 20%, le complément étant du carbone). Le revêtement déposé peut être une interphase ayant une fonction de défragilisation du matériau composite qui favorise la déviation de fissures éventuelles parvenant à l'interphase après s'être propagées dans la matrice, empêchant ou retardant la rupture du renfort par de telles fissures. Le revêtement déposé sur les fibres courtes 11 peut être un revêtement monocouche. En variante, le revêtement déposé sur les fibres courtes 11 peut être un revêtement multicouches. Dans ce cas, on peut changer la nature du précurseur entre le dépôt des différentes couches afin de déposer des couches de nature chimique différente.

Après le dépôt de la première couche, la température du réacteur est abaissée, les réactifs gazeux résiduels sont évacués, puis la température est remontée et les réactifs pour la réalisation de la deuxième couche sont injectés dans le réacteur. On peut par exemple déposer une première couche d'un matériau d'interphase et une deuxième couche d'un matériau différent et réfractaire destiné à protéger les fibres durant la formation de la matrice. Un tel matériau de protection peut par exemple être en carbure de silicium. On peut par exemple réaliser un premier dépôt de nitrure de bore ou de pyrocarbone puis un deuxième dépôt de carbure de silicium sur le premier dépôt.

Il est avantageux de déposer sur les fibres courtes du carbone pyrolytique afin de faciliter l'écoulement des fibres revêtues entre elles durant leur manipulation, ce qui participe à réduire davantage encore le risque de former des agrégats parasites. Une fois le revêtement effectué, on récupère les fibres courtes revêtues pour être utilisées comme renfort fibreux discontinu d'un matériau composite.

On fournit à la figure 3 des photographies obtenues par microscopie électronique à balayage de fibres courtes qui ont été revêtues par mise en oeuvre de l'invention. Dans cet exemple, un matériau d'interphase de carbone d'épaisseur environ 600 nm a été déposé sur des fibres courtes Hi-Nicalon-S de diamètre de 12 µm environ, et de longueur comprise entre 50 µm et 200 µm.

On peut préparer un mélange comprenant un liant et les fibres courtes revêtues. Le liant peut par exemple comprendre un polymère, tel qu'une résine thermoplastique ou thermodurcissable, ou un plastifiant. Il peut être avantageux de chauffer le mélange afin de fluidifier le liant pour faciliter le mélange et permettre une meilleure homogénéisation. On forme ensuite une préforme de la pièce à fabriquer par mise en forme du mélange préparé, par exemple par injection du mélange dans la cavité d'un moule. Le liant présent dans la préforme est ensuite éliminé afin d'obtenir une préforme déliantée. L'élimination du liant peut être faite de manière connue en soi, par exemple par pyrolyse dans le cas d'une résine thermodurcissable de sorte à laisser subsister une phase consolidante améliorant la tenue en forme de la préforme fibreuse. La préforme fibreuse n'est pas tissée. La préforme fibreuse est poreuse et sa porosité est destinée à être remplie par une matrice.

La matrice est ensuite formée. La matrice enrobe les fibres courtes. La matrice peut être formée par infiltration à l'état fondu de la porosité de la préforme poreuse par une composition fondue comprenant du silicium fondu, afin d'obtenir la pièce. La composition fondue peut être constituée de silicium pur fondu ou en variante être sous la forme d'un alliage fondu de silicium et d'un ou plusieurs autres constituants. On obtient alors une pièce en matériau CMC. On peut en variante former un autre type de matrice, comme une matrice organique ou carbone. Diverses techniques de formation de la matrice sont envisageables comme l'infiltration chimique en phase vapeur ou les procédés d'infiltration et pyrolyse de précurseurs de matrice à l'état liquide. La pièce peut alors être obtenue par traitement thermique du mélange introduit dans le moule, par exemple afin de réticuler le matériau de matrice ou pyrolyser le précurseur. On peut ou non appliquer une contrainte mécanique lors du traitement thermique pour densifier davantage le composite. On peut aussi former la matrice par pressage à chaud d'un mélange comprenant les fibres courtes revêtues et une poudre destinée à former la matrice avec ou sans liant.

La pièce obtenue peut être une pièce de turbomachine, par exemple de turbomachine aéronautique ou de turbomachine industrielle. La pièce obtenue peut être une pièce de turbine. La pièce obtenue peut être une aube de turbomachine, par exemple une aube de turbine. La pièce obtenue peut en variante être un secteur d'anneau de turbine.

L'expression « compris(e) entre ... et ... » doit se comprendre comme incluant les bornes.

## Revendications

1. Procédé de revêtement de fibres, comprenant au moins :
- le désensimage de fibres courtes ensimées ayant une longueur moyenne inférieure ou égale à 5 mm, les fibres courtes étant en matériau céramique ou en carbone,
- le tamisage des fibres courtes désensimées afin de les séparer d'éventuels agglomérats de fibres courtes ensimées encore présents,
- l'introduction des fibres courtes désensimées et tamisées dans un réacteur, et
- le revêtement des fibres courtes dans le réacteur par dépôt chimique en phase vapeur en lit fluidisé.

2. Procédé selon la revendication 1, dans lequel le tamisage des fibres courtes désensimées comprend un passage de ces fibres au travers d'un premier tamis ayant une pluralité de premiers trous présentant une première taille moyenne afin d'obtenir un premier tamisat, et un passage du premier tamisat au travers d'un deuxième tamis ayant une pluralité de deuxièmes trous présentant une deuxième taille moyenne inférieure à la première taille moyenne afin d'obtenir un deuxième tamisat formant les fibres courtes désensimées et tamisées.

3. Procédé selon la revendication 2, la première taille moyenne est inférieure ou égale à 500 µm et la deuxième taille moyenne inférieure ou égale à 200 µm.

4. Procédé selon l'une quelconque des revendications 1 à 3, dans lequel on réalise, durant le revêtement, un brassage des fibres courtes à l'aide d'un organe de brassage.

5. Procédé selon la revendication 1 à 4, dans lequel on impose un mouvement de vibration audit réacteur durant le revêtement à l'aide d'un organe vibrant.

6. Procédé selon l'une quelconque des revendications 1 à 5, dans lequel on dépose sur les fibres courtes durant le revêtement au moins une couche de : carbone pyrolytique, de nitrure de bore, de nitrure de bore dopé au silicium, de nitrure de silicium ou de carbone dopé au bore.

7. Procédé de fabrication d'une pièce en matériau composite, comprenant au moins :
- la mise en oeuvre d'un procédé selon l'une quelconque des revendications 1 à 6 afin d'obtenir des fibres courtes revêtues,
- la mise en forme des fibres courtes revêtues de sorte à former une préforme poreuse de la pièce à obtenir, et
- la formation d'une matrice dans la porosité de la préforme afin d'obtenir la pièce en matériau composite.

8. Procédé selon la revendication 7, dans lequel la matrice est formée par infiltration d'une composition de silicium fondu ou d'un alliage de silicium fondu dans la porosité de la préforme.

9. Procédé de fabrication d'une pièce en matériau composite, comprenant au moins :
- la mise en oeuvre d'un procédé selon l'une quelconque des revendications 1 à 6 afin d'obtenir des fibres courtes revêtues,
- le mélange des fibres courtes revêtues avec le matériau de matrice ou avec un précurseur de matrice, et
- l'introduction du mélange ainsi obtenu dans un moule et le traitement thermique du mélange introduit afin d'obtenir la pièce en matériau composite.

## Patentansprüche

1. Verfahren zur Beschichtung von Fasern, mindestens umfassend:
- Entschlichten von geschlichteten Kurzfasern, die eine Durchschnittslänge unter oder gleich 5 mm aufweisen, wobei die Kurzfasern aus einem Keramikmaterial oder aus Kohlenstoff bestehen,
- Sieben der entschlichteten Kurzfasern, um sie von eventuellen Agglomeraten von noch vorhandenen geschlichteten Kurzfasern zu trennen,
- Eingeben der entschlichteten und gesiebten Kurzfasern in einen Reaktor, und
- Beschichten der Kurzfasern in dem Reaktor durch chemische Abscheidung aus der Dampfphase in einem Wirbelbett.

2. Verfahren nach Anspruch 1, wobei das Sieben der entschlichteten Kurzfasern einen Durchgang dieser Fasern durch ein erstes Sieb, das mehrere erste Löcher mit einer ersten mittleren Größe aufweist, um eine erste Siebkörnung zu erlangen, und einen Durchgang der ersten Siebkörnung durch ein zweites Sieb umfasst, das mehrere zweite Löcher mit einer zweiten mittleren Größe kleiner als die erste mittlere Größe aufweist, um eine zweite Siebkörnung zu erlangen, die entschlichtete und gesiebte Kurzfasern ausbildet.

3. Verfahren nach Anspruch 2, wobei die erste mittlere Größe kleiner oder gleich 500 µm ist und die zweite mittlere Größe kleiner oder gleich 200 µm ist.

4. Verfahren nach einem der vorhergehenden Ansprüche 1 bis 3, wobei während der Beschichtung ein Mischen der Kurzfasern mittels eines Mischelements ausgeführt wird.

5. Verfahren nach Anspruch 1 bis 4, wobei der Reaktor während der Beschichtung mittels eines Vibrationselements einer Vibrationsbewegung ausgesetzt ist.

6. Verfahren nach einem der vorhergehenden Ansprüche 1 bis 5, wobei während der Beschichtung mindestens eine Schicht des Folgenden auf den Kurzfasern abgelagert wird: Pyrokohlenstoff, Bornitrid, mit Silizium dotiertes Bornitrid, Siliziumnitrid oder mit Bor dotierter Kohlenstoff.

7. Verfahren zur Herstellung eines Teils aus einem Verbundwerkstoff, mindestens umfassend:
- Durchführen eines Verfahrens nach einem der Ansprüche 1 bis 6, um beschichtete Kurzfasern zu erlangen,
- Formen der beschichteten Kurzfasern derart, dass eine poröse Vorform des zu erlangenden Teils ausgebildet wird,
- Ausbilden einer Matrize in der Porosität der Vorform, um das Teil aus Verbundwerkstoff zu erlangen.

8. Verfahren nach Anspruch 7, wobei die Matrize durch Infiltration einer Zusammensetzung aus geschmolzenem Silizium oder einer Legierung aus geschmolzenem Silizium in der Porosität der Vorform ausgebildet ist.

9. Verfahren zur Herstellung eines Teils aus Verbundwerkstoff, mindestens umfassend:
- Durchführen eines Verfahrens nach einem der Ansprüche 1 bis 6, um beschichtete Kurzfasern zu erlangen,
- Mischen der beschichteten Kurzfasern mit dem Matrizenmaterial oder mit einem Matrizenvorläufer, und
- Eingeben des derart erlangten Gemischs in eine Form und Wärmebehandeln des eingegebenen Gemischs, um das Teil aus Verbundwerkstoff zu erlangen.

## Claims

1. A method for coating fibers, comprising at least:
- desizing sized short fibers having an average length less than or equal to 5 mm, the short fibers being made of ceramic material or carbon,
- sieving the desized short fibers in order to separate them from any agglomerates of sized short fibers still present,
- introducing the desized and sieved short fibers into a reactor, and
- coating the short fibers in the reactor by chemical vapor deposition in a fluidized bed.

2. The method according to claim 1, wherein sieving the desized short fibers comprises passing these fibers through a first sieve having a plurality of first holes having a first average size in order to obtain first undersized grains, and passing the first undersized grains through a second sieve having a plurality of second holes having a second average size smaller than the first average size in order to obtain second undersized grains forming the desized and sieved short fibers.

3. The method according to claim 2, the first average size is less than or equal to 500 µm and the second average size less than or equal to 200 µm.

4. The method according to any one of claims 1 to 3, wherein the short fibers are stirred during coating using a stirring member.

5. The method according to claim 1 to 4, wherein a vibration movement is imposed on said reactor during coating using a vibrating member.

6. The method according to any one of claims 1 to 5, wherein, during coating, at least one layer of: pyrolytic carbon, boron nitride, boron nitride doped with silicon, silicon nitride or carbon doped with boron is deposited on the short fibers.

7. The method for manufacturing a composite material part, comprising at least:
- implementing a method according to any one of claims 1 to 6 in order to obtain coated short fibers,
- shaping the coated short fibers so as to form a porous preform of the part to be obtained, and
- forming a matrix in the porosity of the preform in order to obtain the composite material part.

8. The method according to claim 7, wherein the matrix is formed by infiltrating a composition of molten silicon or of a molten silicon alloy into the pores of the preform.

9. The method for manufacturing a composite material part, comprising at least:
- implementing a method according to any one of claims 1 to 6 in order to obtain coated short fibers,
- mixing the short fibers coated with the matrix material or with a matrix precursor, and
- introducing the mixture thus obtained into a mold and heat treating the mixture introduced in order to obtain the composite material part.
